Europäisches Patentamt

European Patent Office

Office européen des brevets

(11) Publication number: **0 462 338 A1**

# EUROPEAN PATENT APPLICATION

(21) Application number: **90306749.4**

(22) Date of filing: **20.06.90**

(51) Int. Cl.⁵: **H03H 7/20, H03H 17/08**

(43) Date of publication of application:
**27.12.91 Bulletin 91/52**

(84) Designated Contracting States:
**DE FR GB IT**

(71) Applicant: **Hewlett-Packard Limited**
**Nine Mile Ride**
**Wokingham, Berkshire RG11 3LL(GB)**

(72) Inventor: **Domokos, John**
**4 Royal Gardens**
**Stirling FK8 2RJ Scotland(GB)**

(74) Representative: **Smith, Norman Ian et al**
**F.J. CLEVELAND & COMPANY 40-43**
**Chancery Lane**
**London WC2A 1JQ(GB)**

(54) **Phase shifting circuits.**

(57) A phase shifter is implemented using varicap diodes (30) arranged in the form of a lumped element transmission line. A control unit (24) controls the reverse bias voltage of the diodes (30) to provide a delay which can be varied continuously over a given range. The arrangement can be used in conjunction with a digital phase shifter (10) which provides a delay which can be adjusted in predefined steps. The analog shifter (11) provides continuous variation over the step size of the digital shifter.

Fig.1.

EP 0 462 338 A1

This invention relates to phase shifting circuits.

There is often a requirement to change the relative phase of two signals by inserting a variable delay line or phase shifter in the path of one of the signals. Such requirements exist for example in pattern generators and error detectors. It is important in such applications to have accurate control of the delay because this facility is used to characterise a system which is under test. For such applications the phase shifters need to operate over a frequency band of 100 MHz to 3 GHz and to provide delays of which typically are up to 1 nSec.

One type of known phase shifter is the motor driven trombone line which can be used to achieve fine resolution and a broad band width of dc up to approximately 18 GHz. However, the delay which can be provided by such devices is restricted to approximately 500 pSec due to mechanical constraints. A major disadvantage of the motor driven trombone line is that after repeated operation its sliding contacts and other mechanical parts wear out. This leads to a deterioration in performance and reliability. Furthermore, it relies for its operation on a complicated servo system which has relatively slow operation.

A larger range can be implemented using several cascading switched delay sections of transmission lines. However the resolution of this arrangement is limited by the number of sections used.

It is also known to implement phase shifters using Schottky barrier diodes and varactor or varicap diodes. Such devices can provide variable phase shifts by varying the capacitance of the devise. It is usual to implement phase shifters such devices by using a hybrid coupler. As a consequence the band width over which these devices can operate is relatively limited.

The present invention is concerned with the a phase shifter which can provide phase shifts of relatively high accuracy and resolution over a broad band of frequencies.

According to one aspect of the present invention there is provided a phase shifting circuit comprising a plurality of sections arranged in the form of a transmission line, each section including an element whose reactance can be varied, and control means for controlling the reactance of said elements to provide a required phase shift. The elements may comprise diodes having an adjustable capacitance. The sections may include an inductive component.

The control means may provide a voltage signal for adjusting the reactance of said elements. The control means may include memory means arranged to store pre-calculated data, and a control unit responsive to data indicative of a required phase shift to access said memory and on the basis of the accessed data to output a control signal for controlling the variable reactive elements so that the required phase shift is provided. The control signal may be fed to said elements via a digital-to-analog converter.

Another aspect of the present invention provides a phase shifter having a first stage which can provide incremental phase shifts of preselected steps, a second stage which can provide a continuous phase shift variation over at least the minimum step size of the first stage, and control means for controlling said sections to provide a required phase shift. The second stage may comprise a phase shifting circuit in accordance with said one aspect.

The invention will be described now by way of example only, with particular reference to the accompanying drawings. In the drawings:

Figure 1 is a block schematic diagram of a phase shifter in accordance with the present invention;

Figure 2 is a circuit diagram showing part of the phase shifter of Figure 1;

Figures 3A and 3B show the analog part of the phase shifter of Figure 1, Figure 3A being a circuit diagram and Figure 3B showing the circuit layout.

Figure 4 summariese the characteristics of a fourteen section 3GHz phase shifter of the type shown in Figure 3;

Figure 5 contains equations which explain the operation of the phase shifter of Figure 3, and

Figures 6 to 10 are graphs illustrating the operation of the present phase shifter.

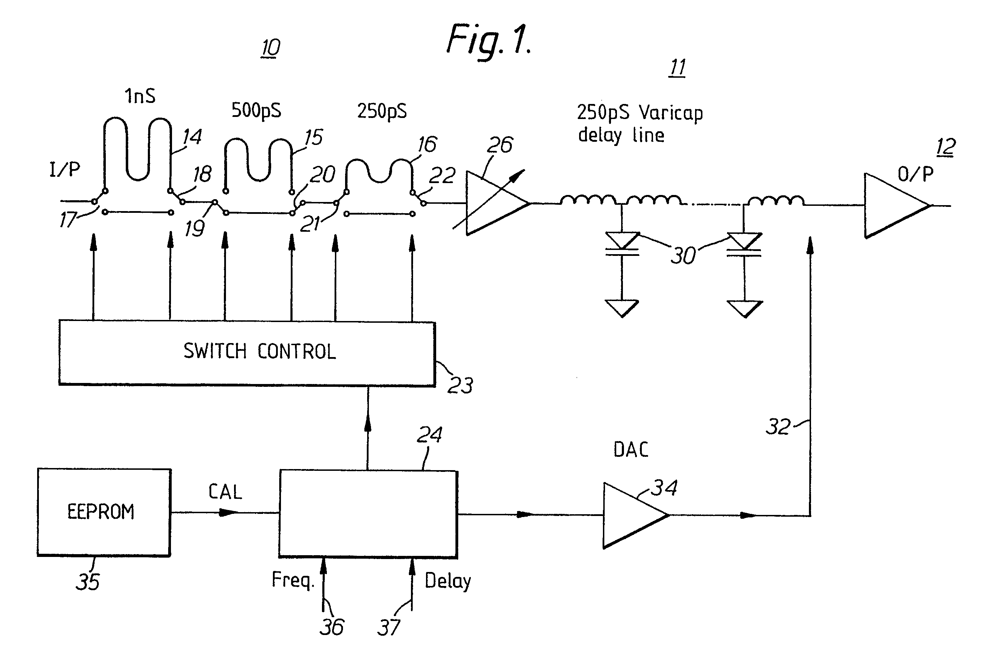

Referring to Figure 1 a phase shifter comprises a first stage (10), a second stage (11) and an output stage (12). The first stage (10) has three delay line sections (14, 15 and 16) which can be switched into or out of a signal path by operation of switches (17 to 22). The switches are operated under the control of a switch control circuit shown generally at (23) which receives input signals from a control unit (24).

The first stage (10) is coupled to the second stage (11) by means of a variable gain amplifier (26). The second stage comprises a plurality of varicap diodes shown at (30) which are connected together to form a lumped element transmission line. The capacitance of this line is dependent upon the reverse bias voltage which is applied to each of the varicap diodes, this bias being controlled by signals fed from the control unit (24) along line (32) by way of a digital-to-analog converter (34).

The phase shifter also includes an EEPROM (35) which stores pre-calibrated data relating to the signals to be applied to the switch control (23) and the varicap diodes (30) in order to provide a required delay at a given frequency. Data indicative of the required delay and the operating frequency are fed to the control unit (24) over lines (36 and 37).

In operation data indicative of the required delay is fed to the control unit (24) which then accesses the EPROM and, on the basis of the accessed data, transmits appropriate signals to the switch control unit (23) and to the varicap diodes to control the stages (10 and 11) to provide the required delay. The switches of the stage (10) are operated to provide the appropriate step delay which will be one of zero, 250 pSecs, 500 pSecs, 750 pSecs, 1 nSec, 1.25 nSec, 1.5 nSec, or 1.75 nSec. The stage (11) can be adjusted to give a variable delay over the range 0 to 250 pSec, that is to say it is continuously variable over the step size provided by the stage (10). Thus it will be seen that by a combination of a digital step phase shifter and an analog continuous phase shifter it is possible to provide a continuous range of delays of between 0 Sec and 2 nSec. The circuit has the advantage that it can be operated over a relatively broad band width.

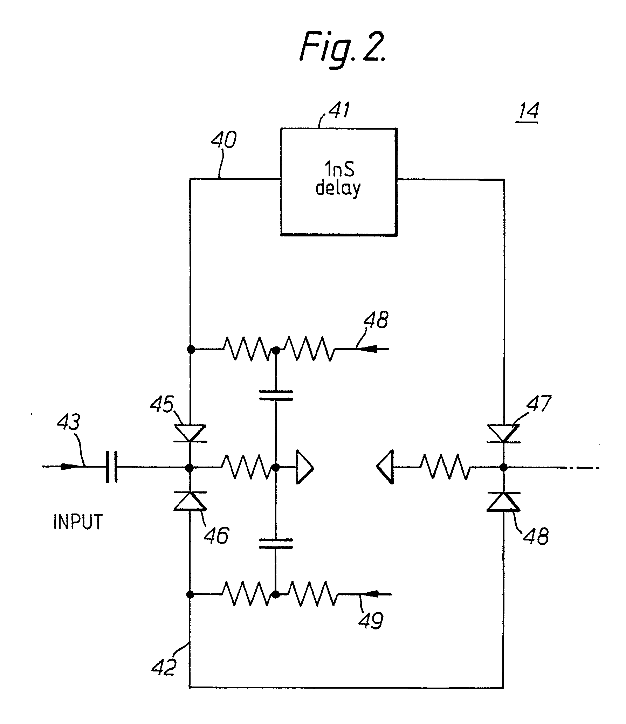

Referring now to Figure 2 this shows in more detail an example of one of the three switched sections which make up the stage (10). The other two sections are substantially identical with the exception of the delay they provide. Each section includes a first path (40) which includes a delay element (41) which provides the fixed delay. The delay element (41) can be for example a conventional microstrip printed track. Each section also includes a second path (42) which does not include any delay element. The input signal applied at input (43) follows either path (40) or (42) depending upon the state of PIN diode switches (45, 46, 47, 48). The switches are controlled by signals applied to terminals (48, 49) by the control unit (24) of Figure 1.

In use when a positive voltage is applied to terminal (48) the diodes (45 and 47) are turned on and the signals path is by way of delay element (41) so that the signal in question is delayed by 1 nSec for the example shown in Figure 2. Alternatively if the positive voltage is applied to terminal (49) then diodes (46 and 48) are turned on so that the signal follows path (42) without any delay.

The low frequency response of the section shown in Figure 2 is determined by the coupling capacitor and the minority carriers lifetime of the PIN diodes. Thus the cut-off frequency can be considerably lower than 100 MHz and even dc coupling is possible with the use of FET switches. The high frequency limit of the switches can be at least 20 GHz with current technology.

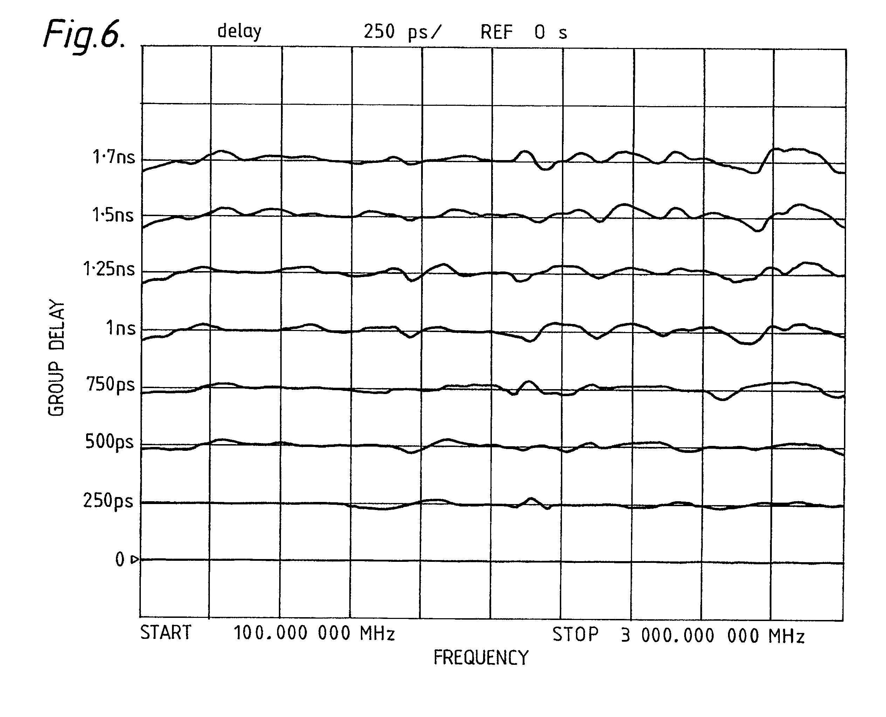

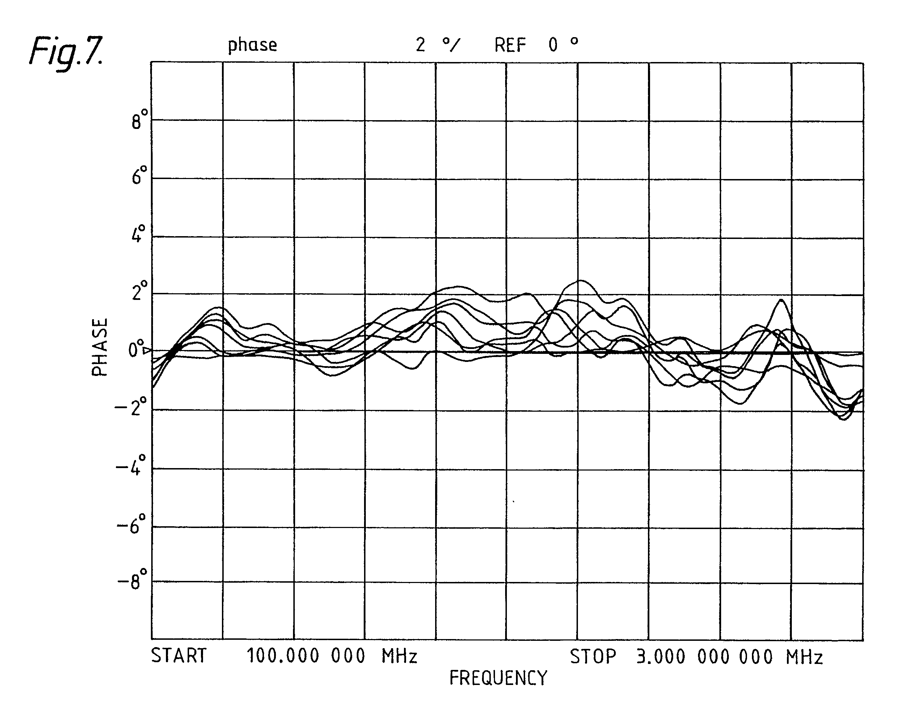

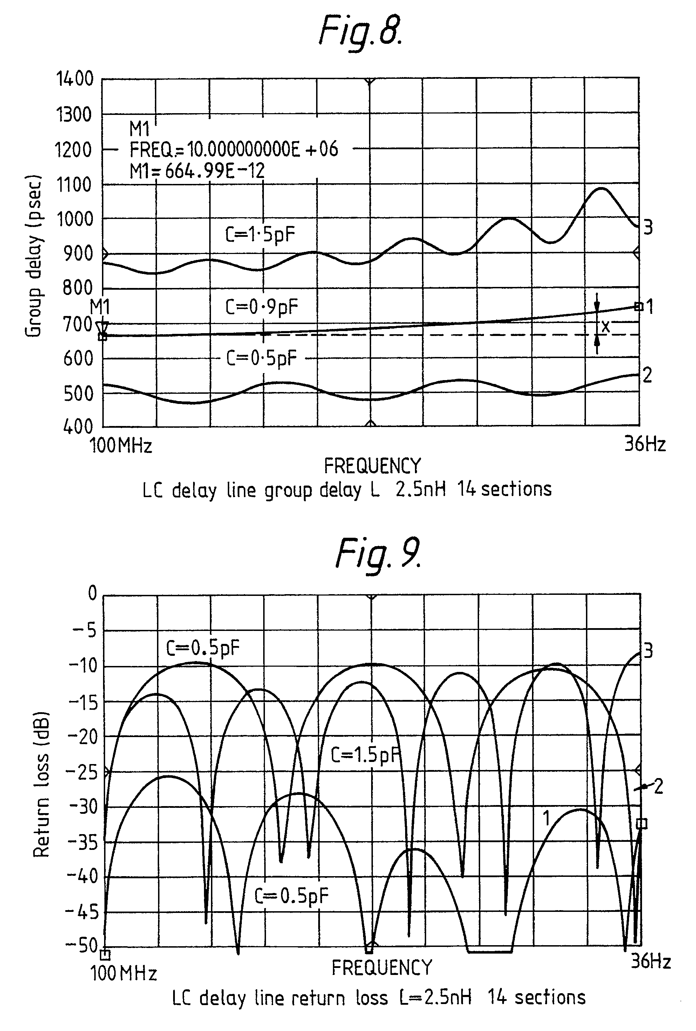

The overall group delay of the three cascaded sections (14 to 16) which make up the stage (10) is illustrated in Figure 6 of the drawings. This Figure shows the frequency response for each step delay provided by the stage. The ripple shown on this Figure is caused by multiple reflections which occur at the switches due to their voltage standing wave ratio (VSWR). This problem would exacerbated if a larger number of sections were used.

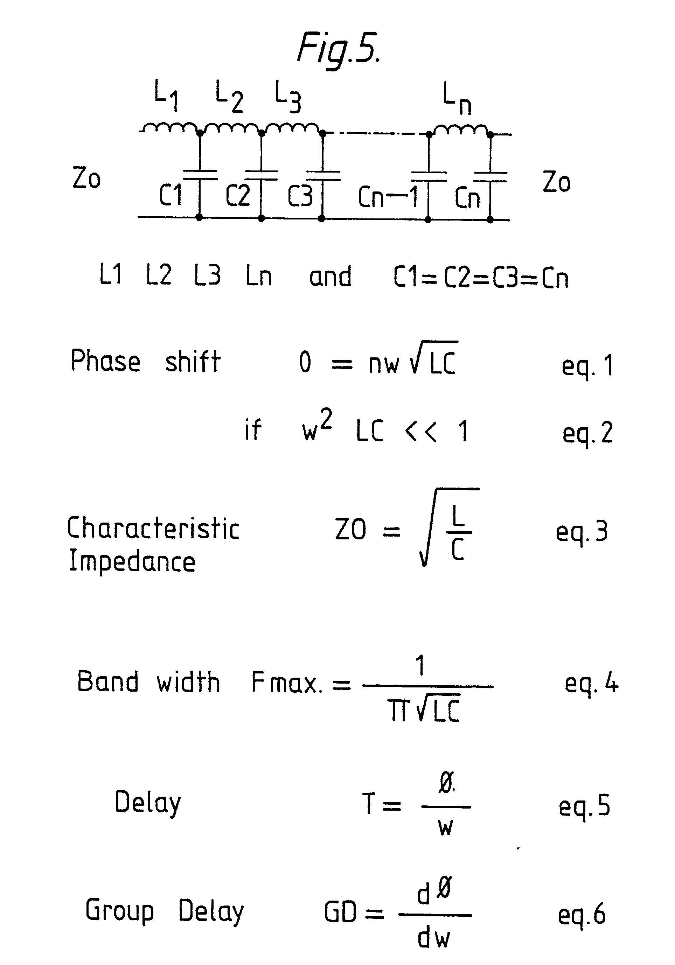

It should be noted that the group delay is a derivative of the frequency and therefore the ripple on Figure 6 exceeds the actual variation in delay. The relationship between the delay and the group delay is defined by equations 5 and 6 shown on Figure 5. The delay ripple can be derived from Figure 7 which shows the phase response plotted against frequency for all combinations of delay settings with a reference delay set to compensate for the fixed delay to achieve a flat phase display in all cases.

The interaction between the switches causes a phase ripple of +/- 2.5° which corresponds to 2.5 pSec at 3 GHz and 5 pSec at 1.5 GHz. One of the advantages of the present arrangement is that even this small error can be compensated by means of appropriate calibration of the stage (11). This makes it possible to satisfy the contradictory requirements of both large range and high resolution.

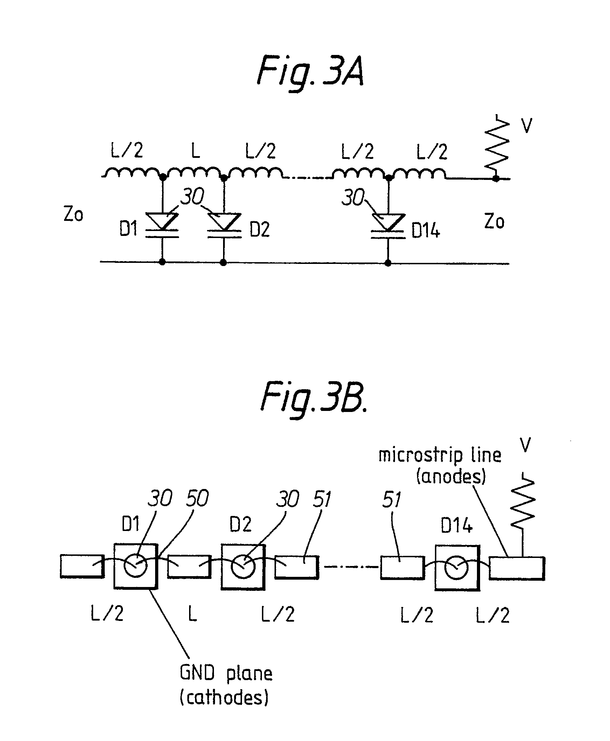

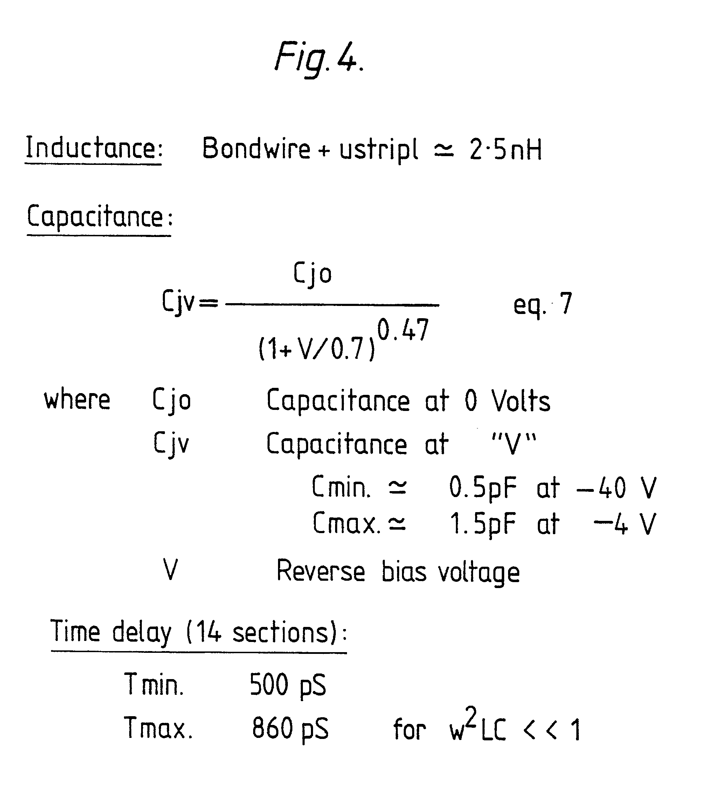

As has been explained the varicap diodes of the stage (11) form a lumped element transmission line, which is represented in Figure 3A of the drawings. The capacitance of the line is determined by the reverse bias voltage applied to the varicap diodes. The capacitance of the line is given by equation 7 in Figure 4. Figures 3A, 3B of the drawings show the stage (11) in slightly more detail and it can be seen that inductances L and L/2 are provided by connecting bond wires (50) and microstrip tracks (51) between the diode sections (30). The microstrip line sections (51) act as cathodes and a ground plane (53) acts as a cathode.

The operation of the stage (11) is described by the equations 1 to 7. As can be seen from equation 1 the phase shift is proportional to $\sqrt{c}$ so that when the capacitance of the diodes is changed the phase shift and hence the delay varies in proportion to $\sqrt{c}$. The overall phase shift of the line is determined by the number of cascaded sections, i.e. the electrical length of the line.

From equations 1 and 4 it will be apparent that there is a compromise to be made between the bandwith, the range and the number of diodes used. For large band width the phase shift per section needs to be kept small.

It will be seen that equation 1 is valid only if the line is operating well below the resonant frequency given by equation 2. In practical arrangements in order to reduce the number of diodes the line may be used near its resonant frequency. This effect is simulated on Figure 8. In this Figure trace 1 shows the group delay line when C equals .9 PF and thus the resonant frequency FMAX equals 6.7 GHz. The deviation from the linear delay is marked on the drawing by X. This error can be calibrated out by the control unit (24), but the phase distortion should be kept to a minimum if the process signals contain higher order harmonics.

As the line capacitance is varied the characteristic impedance of the line also change from ZMIN to ZMAX because of equation 3. This effect is illustrated in Figure 9 which shows return loss plotted against frequency for different values of C. The effect can lead to a standing wave pattern on the line which might result in a group delay ripple. Traces 2 and 3 of Figure 8 correspond to the minimum and maximum capacitance when a worst case mismatch occurs. Trace 1 is smooth because the line impedance is nominal.

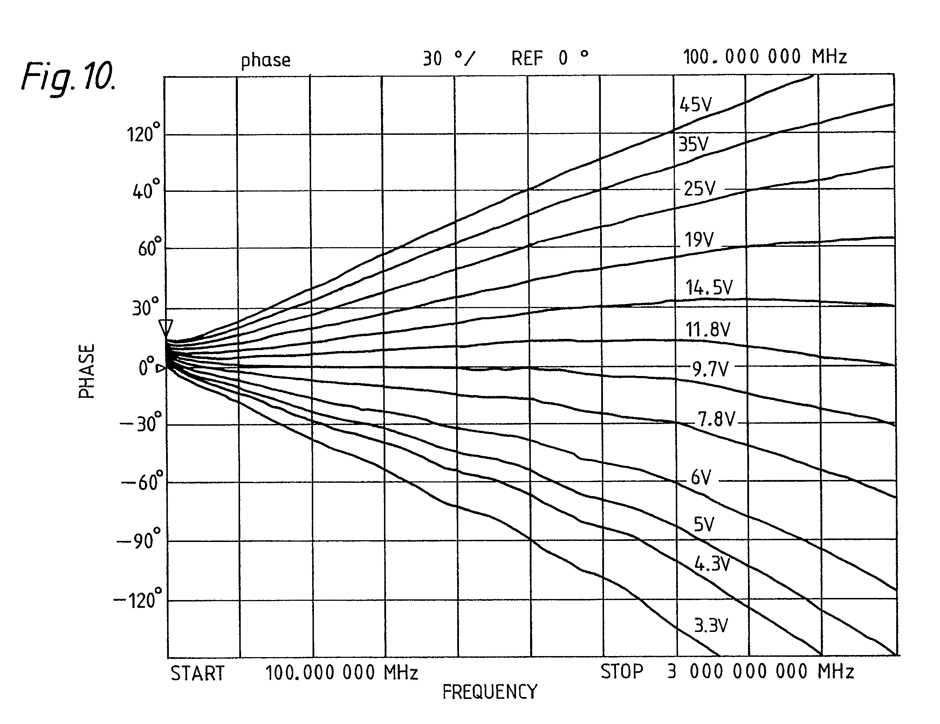

It should be noted that Figure 8 is a group delay plot. The actual delay ripple is considerably less than the group delay as previously explained. The measured phase response of the delay line stage (11) is given in Figure 10. This Figure shows the phase response for several values of reverse bias voltage.

The digital-to-analog converter (34) determines the resolution of the arrangement. The worst resolution occurs at the maximum delay of the stage (11) because of the non-linearity of equations 1 and 7. A 3 GHz phase shifter can achieve .3 pSec resolution with a 12-bit digital-to-analog converter (34).

Turning again to Figure 2 it can be seen that for example the diode (45) and its associated resistances form a $\pi$ attenuator. The advantage of this arrangement is that it reduces reflection which can occur at the switches. However, because it is an attenuator it reduces the signal level and hence the variable gain amplifier (26) is provided to make up for this attenuation and thereby correct for the overall gain tolerances.

The output limiting amplifier (12) provides constant amplitude regardless of the phase adjustment and frequency. In addition to this the amplifier reduces the overshoot caused by the band limitation of the process signal due to the finite band width of the delay line stage (11).

## Claims

1. A phase shifting circuit characterised in that it comprises a plurality of sections (30) arranged in the form of a transmission line, each section including an element (30) whose reactance can be varied, and control means (24, 34, 35) for controlling the reactance of said elements to provide a required phase shift.

2. A phase shifting circuit according to claim 1, wherein the elements (30) comprise diodes whose capacitance can be varied.

3. A phase shifting circuit according to claim 2, wherein each section includes an inductive component (50, 51).

4. A shifting circuit according to any preceding claim, wherein the control means (24, 34, 35) provides a voltage signal for adjusting the reactance of said elements.

5. A phase shifting circuit according to claim 4, wherein the control means include memory means (35) arranged to store pre-calculated data, and a control unit (24) responsive to data indicative of a required phase shift to access said memory and on the basis of the accessed data to output a control signal for controlling the variable reactive elements so that the required phase shift is provided.

6. A phase shifting circuit according to claim 5, wherein the control signal may be fed to said elements (30) via a digital-to-analog converter (34).

7. A phase shifting circuit characterised in that it comprises comprising a first stage (10) which can provide
incremental phase shifts of preselected steps, a second stage (11) which can provide a continuous phase shift variation over at least the minimum step size of the first stage, and control means (24, 34, 35) for controlling said stages to provide a required phase shift.

8. A phase shifting circuit according to claim 7, wherein said second stage (11) comprises a circuit according to any one of claims 1 to 6.

9. A phase shifting circuit according to claim 8, wherein said first stage (10) comprises a plurality of delay elements (14, 15, 16) which can be switched into or out of a signal path by under the control of said control means (24, 34, 35).

10. A phase shifting circuit according to claim 9, wherein the delay elements (14, 15, 16) are switched into or out of the signal path by PIN diodes (45 to 58).

11. A phase shifting circuit according to any one of claims 7 to 10 including a variable gain amplifier (26) compensating for signal loss.

Fig.1.

*10*

*11*

1nS

500pS

250pS

250pS Varicap delay line

I/P

*14*

*15*

*16*

*26*

*12*

O/P

*18*

*20*

*22*

*17*

*19*

*21*

*30*

SWITCH CONTROL

*23*

*24*

*32*

DAC

*34*

EEPROM

CAL

*35*

Freq.

Delay

*36*

*37*

EP 0 462 338 A1

# Fig. 2.

## Fig. 3A

## Fig. 3B.

# *Fig. 4.*

<u>Inductance:</u>   Bondwire + ustripl $\simeq$ 2·5nH

<u>Capacitance</u>:

$$Cjv = \frac{Cjo}{(1+V/0.7)^{0.47}} \qquad \text{eq. 7}$$

where   Cjo      Capacitance at 0 Volts

Cjv      Capacitance at  "V"

Cmin. $\simeq$   0.5pF  at  −40 V

Cmax. $\simeq$   1.5pF  at   −4 V

V         Reverse bias voltage

<u>Time delay (14 sections):</u>

Tmin.      500 pS

Tmax.      860 pS        for  $w^2 LC \ll 1$

# Fig.5.

L1  L2  L3  Ln    and    $C1 = C2 = C3 = Cn$

Phase shift    $0 = nw\sqrt{LC}$    eq. 1

if    $w^2 LC \ll 1$    eq. 2

Characteristic
Impedance    $Z0 = \sqrt{\dfrac{L}{C}}$    eq. 3

Band width    $Fmax. = \dfrac{1}{\pi\sqrt{LC}}$    eq. 4

Delay    $T = \dfrac{\emptyset}{w}$    eq. 5

Group Delay    $GD = \dfrac{d\emptyset}{dw}$    eq. 6

9

Fig.6.

Fig.7.

EP 0 462 338 A1

## Fig.8.

LC delay line group delay L  2.5nH  14 sections

## Fig.9.

LC delay line return loss L=2.5nH  14 sections

Fig.10.

EP 0 462 338 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, vol. 12, no. 94 (E-593), 26th March 1988; & JP-A-62 226 708 (UNYUSHO) 05-10-1987 * Abstract; figures 1-3,7,10 * | 1,2,4,7 -9 | H 03 H 7/20 H 03 H 17/08 |
| Y | IDEM | 3,10 | |
| A | IDEM | 6 | |
| Y | IEEE TRANSACTIONS ON MICROWAVE THEORY & TECHNIQUES, vol. MTT-22, Nr. 6, June 1974, pages 675-688, New York, US; R.W. BURNS et al.: "Low cost design techniques for semiconductor phase shifters" * Abstract; page 675, right-hand column, line 15 - page 676, line 24; page 677, right-hand column, lines 23-24; figures 1,9 * | 3,10 | |
| A | PATENT ABSTRACTS OF JAPAN, vol. 13, no. 330 (E-793), 25th July 1989; & JP-A-01 093 910 (CLARION) 12-04-1989 * Abstract * | 5 | TECHNICAL FIELDS SEARCHED (Int. Cl.5) H 03 H H 01 P |
| A | PATENT ABSTRACTS OF JAPAN, vol. 10, no. 248 (E-431), 26th August 1986; & JP-A-61 077 410 (MITSUBISHI) 21-04-1986 * Abstract * | 11 | |

The present search report has been drawn up for all claims

| Place of search | Date of completion of the search | Examiner |
|---|---|---|
| THE HAGUE | 14-02-1991 | WRIGHT J.P. |

EPO FORM 1503 03.82 (P0401)